# FASCICULE DE BREVET EUROPEEN

(11) **EP 0 741 910 B1**
(45) Date de publication et mention de la délivrance du brevet: **28.04.2004**
(21) Numéro de dépôt: 95907695.1
(22) Date de dépôt: 25.01.1995
(51) Int. Cl.: H01L 21/58, H01L 21/473, H01L 21/48

(54) **STRUCTURE PRESENTANT DES CAVITES ET PROCEDE DE REALISATION D'UNE TELLE STRUCTURE**
STRUKTUR MIT KAVITÄTEN UND HERSTELLUNGSVERFAHREN FÜR SOLCH EINE STRUKTUR
CAVITY-CONTAINING STRUCTURE AND METHOD FOR MAKING SAME

(30) Priorité: 26.01.1994 FR 9400835
(43) Date de publication de la demande: 13.11.1996
(73) Titulaire: COMMISSARIAT A L'ENERGIE ATOMIQUE, 75015 Paris (FR)
(72) Inventeur: BRUEL, Michel, F-38113 Veurey (FR)
(74) Mandataire: Audier, Philippe André
(86) Numéro de dépôt international: PCT/FR1995/000078
(87) Numéro de publication internationale: WO 1995/020824

(56) Documents cités:
- WO-A-92/05575
- FR-A- 2 681 472
- US-A- 4 121 334
- US-A- 4 567 505
- US-A- 4 894 709
- US-A- 5 070 040
- WELDING AND METAL FABRICATION, vol.59, no.5, Juin 1991, HAYWARDS HEATH GB K.I. JOHNSON ET AL. 'Current and Future Trends in Microjoining'
- IEEE ELECTRON DEVICE LETTERS., vol.14, no.1, Janvier 1993, NEW YORK US A. GOYAL ET AL. 'Formation of Silicon Reentrant Cavity Heat Sinks Using Anisotropic Etching and Direct Wafer Bonding' cité dans la demande
- JOURNAL OF THE ELECTROCHEMICAL SOCIETY, vol.138, no.6, Juin 1991, MANCHESTER, NEW HAMPSHIRE US pages 1706 - 1709 R. RAMESHAM ET AL. 'Fabrication of Microchannels in Synthetic Polycrystalline Diamond Thin Films for Heat Sinking Applications'

## Description

### Domaine technique

La présente invention a pour objet un procédé de réalisation d'une structure comportant un substrat apte à supporter une tranche superficielle en un matériau non-conducteur pour la réalisation éventuelle de circuits intégrés et des cavités internes disposées sous la tranche superficielle dans le substrat, ainsi qu'un procédé de réalisation d'une telle structure.

L'invention s'applique en général aux domaines de la microélectronique et en particulier aux dispositifs de microélectronique nécessitant une bonne dissipation thermique.

### Etat de la technique antérieure

Des structures comportant des cavités internes sont connues en microélectronique, notamment pour leur propriété de dissipation thermique. Le document (1) "Formation of Silicon Reentrant Cavity Heat Sinks Using Anisotropic Etching and Direct Wafer Bonding" de Ajay Goyal et al., IEEE Electron Deviez Létters, vol. 14, n°1, Janvier 1993, en donne une illustration.

Ce document révèle une structure en deux parties. Une première partie sert de substrat pour la réalisation de circuits intégrés, par exemple. Elle est solidarisée sur une seconde partie dans laquelle sont gravées des cavités. Ce document suggère aussi l'utilisation d'un fluide de refroidissement à l'intérieur des cavités. Les cavités permettent, par exemple, de retenir des vapeurs du fluide de refroidissement et confèrent à la structure la propriété d'absorber d'importantes excursions thermiques du ou des circuits intégrés de la première partie.

De façon générale, dans de telles structures, et pour des raisons technologiques de fabrication essentiellement, la première partie, portant les circuits intégrés est relativement épaisse.

L'épaisseur de cette partie constitue d'ailleurs une des principales limitations de l'efficacité de la dissipation thermique par les cavités, car la chaleur produite doit traverser cette épaisseur avant de parvenir à la seconde partie comportant les cavités.

Un but de la présente invention est justement la réalisation de structures en deux parties où la première partie comportant éventuellement des circuits intégrés est très fine et où la seconde partie est pourvue de cavités.

Le fait de disposer d'une première partie fine permet d'envisager pour les structures des applications diverses où les cavités peuvent aussi remplir des fonctions autres que celle de la dissipation thermique. Il est, par exemple, possible, en pratiquant des ouvertures dans la première partie fine, de réaliser dans les cavités de la seconde partie d'autres opérations technologiques telles que des dépôts métalliques pour réaliser des connexions et/ou des électrodes ou des opérations permettant la réalisation d'éléments divers.

### Exposé de l'invention

Pour augmenter l'efficacité de la dissipation thermique des structures en deux parties évoquées dans ce qui précède et/ou pour envisager des utilisations nouvelles de ces structures, l'invention a plus précisément pour objet un procédé de réalisation d'une structure défini par la revendication 1.

On entend par solidarisation toute opération entre le substrat et la plaquette permettant d'assurer une énergie de liaison suffisante entre ces deux éléments pour qu'ils ne se dissocient pas au cours des opérations ultérieures.

on peut citer par exemple des opérations de traitements de surface permettant d'engendrer des liaisons interatomiques, des opérations de collage, etc.

Par ailleurs, on entend par couche non conductrice aussi bien une couche unique réalisée en matériau semi-conducteur ou en matériau isolant qu'un ensemble de sous-couches dont au moins une est réalisée en matériau semi-conducteur ou isolant.

Selon l'invention, la plaquette de matériau non conducteur comporte une partie massive, une couche intermédiaire et un film mince superficiel. Ainsi, on solidarise la plaquette sur le substrat avec le film mince venant sur ladite face du substrat et on amincit la plaquette en séparant le film mince de la partie massive à partir de la couche intermédiaire.

Pour séparer le film mince de la plaquette, on clive la plaquette avec un procédé, de clivage selon un plan de clivage déterminé. On entend par clivage toute séparation préférentiellement selon un plan, en deux parties de la plaquette.

Ce procédé de clivage, particulièrement recommandé pour l'obtention de plaquettes ou de films homogènes et très minces, consiste à implanter par bombardement dans la plaquette des ions de gaz rare ou d'hydrogène pour former une fine couche de microbulles gazeuses qui constitue ladite couche intermédiaire et qui définit un plan de clivage séparant dans la plaquette la partie massive et le film mince. Ce film constitue après clivage la tranche superficielle mince de la structure de l'invention.

Le clivage a lieu simplement en échauffant la plaquette pour créer par un effet de pression dans les microbulles et de réarrangement cristallin, une séparation des deux parties.

Un tel procédé est décrit par exemple dans le document (2) FR-2 681 472. Pour permettre le détachement de la partie superficielle mince sans la déchirer où la déformer, il faut, avant l'opération de clivage, comme le précise le document (2), mettre celle-ci en contact intime avec une structure de maintien appelée "raidisseur".

Conformément à la présente invention, le substrat tient lieu de raidisseur. Avant de solidariser la plaquette sur le substrat, on soumet la plaquette à un bombardement, par exemple d'ions de gaz rare, pour y former une couche de microbulles définissant une partie superficielle mince. Cette partie superficielle vient en contact avec la face du substrat.

De manière tout à fait surprenante, les cavités gravées dans le substrat de support n'empêchent pas le maintien correct de la partie mince de la plaquette. L'invention part de la constatation que le principe de contact intime entre la plaquette à cliver et le substrat, peut être localement violé. Cette propriété est vérifiée lorsque les cavités présentent chacune dans le plan de la face gravée du substrat au moins une dimension ℓ inférieure ou égale à une valeur maximale ℓₒ fonction de l'épaisseur de la tranche superficielle que l'on veut obtenir.

On entend par dimension ℓ de la cavité, soit le diamètre de celle-ci lorsqu'elle est de forme cylindrique ou hémisphérique, soit une largeur ou une longueur. Dans un cas particulier où les cavités sont des tranchées, la dimension ℓ sera la largeur de ces tranchées.

Lorsque la plaquette est en silicium, ℓₒ est choisie proportionnelle à l'épaisseur eₒ de la tranche superficielle avec ℓₒ=10eₒ. On vérifie donc ℓ≤ℓₒ=10eₒ.

Pour une mise en oeuvre efficace et fiable de l'invention, il convient de contrôler avec précision la largeur des cavités lors de l'opération de gravure de la face du substrat.

La gravure des cavités peut être mise en oeuvre par tout procédé connu tel qu'avantageusement une gravure sèche classique ou une technique laser comme décrite ci-dessous.

Cette dernière gravure a lieu selon une technique alliant une attaque chimique anisotrope et un usinage par faisceau laser. Cette technique est basée sur la différence de vitesse d'attaque des plans cristallographiques <111> par rapport aux autres plans cristallographiques.

Selon cette technique, on détruit localement, selon les motifs des cavités à réaliser, les plans cristallographiques <111> par fusion locale de la couche à graver au moyen d'un faisceau laser. Dans un deuxième temps, un traitement chimique permet d'éliminer les zones attaquées par le faisceau laser, les plans <111> non détruits par le faisceau laser servant alors de "couche d'arrêt". Grâce à cette technique, il est possible d'obtenir des canaux dont on peut contrôler très précisément la largeur, la profondeur et l'emplacement.

Le document "Laser Machining and Anisotropic Etching of <111> Silicon for Applications in Microsystems" de M. Alavi et al. dans "Micro System Technologies 92", 3rd International Conference on Micro Electro, Opto, Mechanic Systems and Componants, Berlin, Octobre 21-23, 1992, vde-verlag gmbh - Herbert Reichl, Berlin Offenbach, illustre cette technique de gravure

### Brève description des figures

- les figures 1 et 2 sont des coupes schématiques d'un substrat et illustrent une opération de gravure de ce substrat selon l'invention,
- la figure 3 est une coupe schématique d'une plaquette en matériau non-conducteur dans laquelle est réalisée, par implantation, une couche de microbulles gazeuses,
- la figure 4 est une coupe schématique de la plaquette et du substrat et illustre le report de la plaquette sur le substrat,
- la figure 5 est une coupe schématique de la structure de l'invention et illustre une phase de clivage de la plaquette.

### Exposé détaillé de modes de réalisation de l'invention

La première opération du procédé consiste à graver des cavités dans un substrat. Le substrat est par exemple une plaque de matériau semi-conducteur cylindrique.

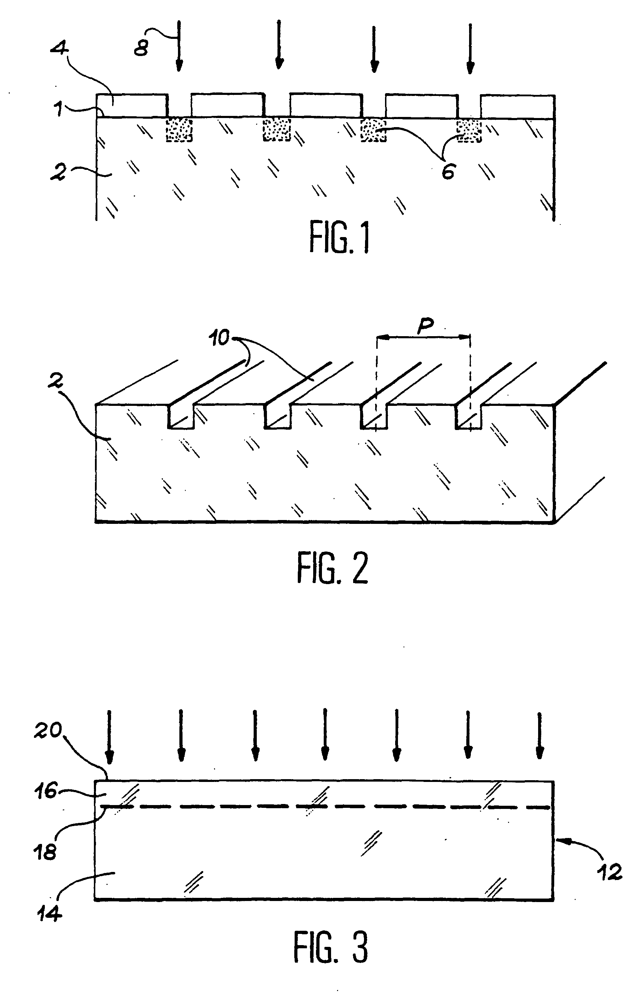

Pour préparer cette gravure, on peut, à titre d'exemple comme l'illustre la figure 1, préparer une face 1 d'un substrat 2 au moyen d'un traitement préalable par faisceau laser. Dans l'exemple décrit, où le substrat 2 est en silicium, un masque 4, par exemple en oxyde de silicium ou en nitrure de silicium, permet de définir des zones 6 dite "zones fondues" dans lesquelles les plans cristallographiques <111> du substrat sont détruits par un faisceau laser 8.

Après ce premier traitement, le substrat 2 est soumis à une gravure chimique. Cette gravure met à profit la différence de la vitesse d'attaque des plans cristallographiques <111> par rapport aux autres plans. En l'occurrence, les plans cristallographiques <111> non détruits par le traitement laser, et entourant les zones fondues 6 servent de "couche d'arrêt" pour la gravure. Il est ainsi possible de former avec grande précision des cavités 10 dans le substrat 2, comme le montre la figure 2. D'autres procédés de gravure peuvent bien entendu convenir également pour la réalisation des cavités 10 du substrat 2.

La forme des cavités peut être très variable, toutefois, dans la réalisation représentée à la figure 2, les cavités 10 sont des tranchées s'étendant en longueur sur la face 1.

Les tranchées 10 peuvent avoir une longueur maximum L de l'ordre de grandeur du diamètre de la face 1 du substrat 2. La largeur des tranchées, mesurée perpendiculairement à leur longueur, dans le plan de la face 1, a conformément à l'invention, une valeur ℓ≤ℓₒ ou ℓₒ est proportionnelle à l'épaisseur de la tranche superficielle mince qui sera réalisée par la suite. On a par exemple ℓₒ=10µm et ℓ=8µm. Ces valeurs conviennent par exemple pour une tranche superficielle d'une épaisseur eₒ de 800 nm. Comme le montre la figure 2, les tranchées sont disposées selon un réseau ; Le pas P de ce réseau est par exemple de l'ordre de 200µm. Pour des raisons de clarté,.la figure 2 ne montre que quatre canaux. Pour un réseau comportant deux séries de canaux orthogonaux, chaque série peut comporter de l'ordre de 500 canaux pour un substrat de l'ordre de 10 cm avec un pas de 200 µm.

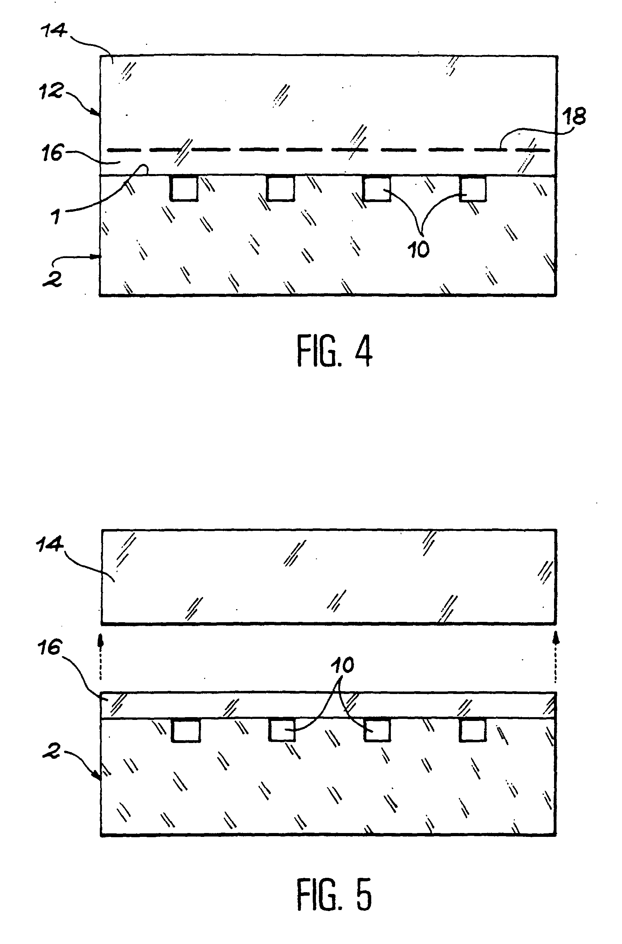

Lorsque les cavités, ou les tranchées sont gravées, une plaquette 12 de matériau non-conducteur est comme le montre la figure 4, solidarisée sur la face 1 du substrat 2. On prendra par exemple une plaquette de silicium monocristallin.

Cette plaquette doit ensuite être amincie pour obtenir une tranche superficielle mince.

L'amincissement de la plaquette 12 a avantageusement lieu par un clivage permettant d'obtenir la tranche superficielle mince. Lors de cette opération de clivage, le substrat 2 joue un rôle de raidisseur pour éviter le déchirement de la tranche mince. La solidarisation entre le substrat 8 et la plaquette 12 est suffisamment solide pour que, malgré la présence des cavités 10, le maintien de la future tranche mince soit assuré.

Pour la solidarisation, une substance adhésive à la fois à la plaquette 12 et au substrat 2 peut convenir. La solidarisation peut, si on ne souhaite pas l'utilisation d'une substance adhésive, être obtenu par la préparation d'au moins une des surfaces à solidariser et par un traitement thermique assorti éventuellement d'un choix de pression pour favoriser les liaisons interatomiques entre le substrat 2 servant de raidisseur et la plaquette 12.

Avant de solidariser la plaquette 12 sur le substrat 2, il convient de définir un plan de clivage qui sépare d'une part une partie massive 14 de la plaquette 12 et une tranche superficielle plus fine 16 qui constitue la future tranche mince.

Le plan de clivage est défini par une très fine couche 18 de microbulles de gaz hydrogène ou de gaz rare réalisée par implantation dans la plaquette 12.

A cet effet, et comme le montre la figure 3, on bombarde une face 20 de la plaquette 12 avec des ions.

A titre d'exemple, on effectue une implantation de protons dans la plaquette 12 de silicium avec une énergie de 90 keV, ce qui permet de former la couche 18 à 800 nm de la face 20 de la plaquette 12, c'est-à-dire l'épaisseur de la future tranche mince.

Quand la couche de microbulles est formée, on peut procéder à la solidarisation précédemment décrit, en mettant en contact la face 1 du substrat 2 et la face 20 de la plaquette 12. On obtient la structure représentée à la figure 4.

Pour cliver cette structure, l'ensemble de la structure de la figure 4 subit un traitement thermique. Il est à noter que tous les traitements thermiques utilisés avant le clivage tels que le bombardement ionique et un éventuel traitement de surface pour la solidarisation doivent être effectués à une température inférieure à celle du clivage. Le traitement thermique du clivage provoque par effet de pression et de réarrangement cristallin un clivage selon la couche de microbulles 18. La partie massive 14 se sépare de la tranche mince 16 qui constitue alors une tranche mince 16, solidaire du substrat 2.

La structure finalement obtenue présente donc en quelques sorte des tunnels constitués par les tranchées recouvertes par la tranche superficielle mince qui peut constituer un support pour la réalisation de circuits intégrés. Etant donné la très faible épaisseur de cette tranche, grâce à l'invention, il est possible par exemple de pratiquer des ouvertures à travers la tranche mince, qui débouchent dans les tranchées ou cavités. Le dépôt de couches métalliques à travers ces ouvertures puis la gravure de structures sur la tranche fine, que l'on peut positionner précisément par rapport aux tranchées grâce à la faible épaisseur de la tranche, offrent des perspectives de réalisation qui n'étaient pas possibles avec une plaquette ou une tranche épaisse.

## Revendications

1. Procédé de réalisation d'une structure comportant un substrat (2), une tranche superficielle mince en un matériau non-conducteur, solidarisée sur une face (1) du substrat (2), ledit substrat (2) présentant des cavités (10) affleurantes à ladite face disposées sous la tranche superficielle mince, le procédé comportant les étapes successives suivantes :
- gravure de cavités (10) dans une face (1) d'un substrat, les cavités présentant dans le plan de la face du substrat au moins une dimension fonction de l'épaisseur de la tranche superficielle, pour assurer un maintien correct de celle-ci,
- solidarisation d'une plaquette (12) de matériau non-conducteur, comportant une partie massive (14), une couche intermédiaire et un film mince (16), sur la face (1) du substrat (2) avec le film mince (16) venant sur ladite face (1),
- amincissement de la plaquette (12) par séparation du film mince (16) et de la partie massive (14) à partir de la couche intermédiaire, pour obtenir la tranche superficielle mince, la couche intermédiaire séparant le film mince (16) et la partie massive étant une couche (18) de microbulles obtenue par implantation d'ions de gaz dans la plaquette, la séparation du film mince étant réalisée par clivage de la plaquette (12) selon un plan de clivage défini par la couche (18) de microbulles.

2. Procédé selon la revendication 1, **caractérisé en ce que** chaque cavité (10) présente dans le plan de la face (1) du substrat (2) au moins une dimension ℓ inférieure ou égale à une valeur maximale ℓₒ proportionnelle à l'épaisseur de la tranche superficielle.

3. Procédé selon la revendication 2, **caractérisé en ce que** la plaquette étant en silicium et présentant une épaisseur eₒ, on a ℓₒ=10·eₒ.

4. Procédé selon la revendication 1, **caractérisé en ce. que** les cavités (10) sont des tranchées longitudinales.

## Patentansprüche

1. Verfahren zur Herstellung einer Struktur mit einem Substrat (2), ein dünnes Oberflächenplättchen aus einem nichtleitenden Material umfassend, das fest verbunden ist mit einer Fläche (1) des Substrats (2), wobei das genannte Substrat (2) glatt mit der genannten Fläche (1) abschließende Hohlräume (10) aufweist, die sich unter dem dünnen Oberflächenplättchen befinden, und das Verfahren die folgenden Schritte umfasst:
- Ätzen von Hohlräumen (10) in einer Fläche (1) eines Substrats, wobei die Hohlräume in der Ebene der Fläche des Substrats wenigstens eine von der Dicke des Oberflächenplättchens abhängige Dimension aufweisen, um sicherzustellen, dass dieses einen einwandfreien Halt hat,
- Befestigen einer Platte (12) aus nichtleitendem Material mit einem massiven Teil (14), einer Zwischenschicht und einer dünnen Schicht (16) auf der Fläche (1) des Substrats (2), mit der dünnen Schicht (16) auf der genannten Fläche (1),
- Dünnermachen der Platte (12) durch Trennung der dünnen Schicht (16) und des massiven Teils (14) mittels der Zwischenschicht, um das dünne Oberflächenplättchen zu erhalten, wobei die die dünne Schicht (16) und den massiven Teil trennende Zwischenschicht eine Mikroblasen-Schicht (18) ist, die man durch Implantation von Gas-Ionen in der Platte herstellt, und die Abtrennung der dünnen Schicht durch Spaltung der Platte (12) in einer Spaltungsebene erfolgt, die durch die Mikroblasenschicht (18) definiert ist.

2. Verfahren nach Anspruch 1, **dadurch gekennzeichnet, dass** jeder Hohlraum (10) in der Ebene der Fläche (1) des Substrats (2) wenigstens eine Dimension ℓ aufweist, kleiner als oder gleich groß wie ein zu der Dicke des Oberflächenplättchens proportionaler Maximalwert ℓₒ.

3. Verfahren nach Anspruch 2, **dadurch gekennzeichnet, dass** ℓₒ=10·eₒ ist, wobei die Platte aus Silicium ist und eine Dicke eₒ aufweist.

4. Verfahren nach Anspruch 1, **dadurch gekennzeichnet, dass** die Hohlräume (10) Längsgraben sind.

## Claims

1. Process for producing a structure incorporating a substrate (2), a thin surface film (16) made from a non-conducting material joined to one face (1) of the substrate (2), said substrate (2) having cavities (10) flush with said face (1) located below the thin surface film, comprises the following successive stages:
- etching cavities (10) in one face (1) of a substrate, the cavities having in the plane of the substrate face at least one dimension which is a function of the thickness of the surface film, in order to correctly secure the latter,
- joining a non-conducting material wafer (12) having a solid portion (14), an intermediate layer and a thin film (16) to the face (1) of the substrate (2) with the film (16) on said face (1),
- thinning the wafer (12) to obtain the thin surface section, the thinning of the wafer being obtained by separating the film (16) of the solid portion (14) from the intermediate layer, in order to obtain the thin surface film, the intermediate layer separating the film (16) and the solid portion being a layer (18) of microbubbles obtained by implanting gas ions in the wafer, the separation of the film being implemented by cleaving the wafer (12) in accordance with a cleaving plane defined by the microbubble layer (18).

2. Process according to claim 1, **characterized in that** each cavity (10) has in the plane of the face (1) of the substrate (2) at least one dimension ℓ equal to or smaller than the maximum value ℓₒ proportional to the thickness of the surface film.

3. Process according to claim 2, **characterized in that** the wafer is of silicon and has a thickness eₒ, giving ℓₒ = 10.eₒ.

4. Process according to claim 1, **characterized in that** the cavities (10) are longitudinal trenches.
